Europäisches Patentamt

European Patent Office

Office européen des brevets

(11) Veröffentlichungsnummer: **0 229 969**
**A2**

(12) **EUROPÄISCHE PATENTANMELDUNG**

(21) Anmeldenummer: 86117062.9

(51) Int. Cl.⁴: **H01H 1/52**

(22) Anmeldetag: 08.12.86

(30) Priorität: 16.01.86 DE 3601139

(43) Veröffentlichungstag der Anmeldung:
29.07.87 Patentblatt 87/31

(84) Benannte Vertragsstaaten:
AT CH DE FR GB IT LI

(71) Anmelder: Hengstler Bauelemente GmbH
Postfach 1249
D-7209 Wehingen(DE)

(72) Erfinder: Seeger, Gunter A., Dipl.-ing.
Heidelberger Landstrasse 341
D-6100 Darmstadt-Eberstadt(DE)

(74) Vertreter: Riebling, Peter, Dr.-ing. et al
Patentanwälte Dr.-ing., Dipl.-ing., ing.(grad.)
Günter Riebling Dr.-ing., Dipl.-ing. Peter
Riebling Rennerie 10 Postfach 3160
D-8990 Lindau(DE)

(54) **Steckbares Relais.**

(57) Ein steckbares Relais ist mit im Gehäuse angeordneten Kontakten lösbar mit zugeordneten Kontakten auf einer Leiterplatte verbunden. Um einen einfachen und kostengünstigen Aufbau des Relais zu erreichen, ist vorgesehen, daß das Relais auf die Leiterplatte erst nach Abschluß aller Lötvorgänge und der nachgeschalteten Bearbeitungsvorgänge auf der Leiterplatte montiert wird. Das Relais muß deshalb nicht den hohen thermischen und chemischen Beanspruchungen standhalten, wie sie im Lötbad und den nachfolgenden Verarbeitungsschriften gegeben sind. Hierzu ist vorgesehen, daß die Kontakte im Relais als Buchsen ausgebildet sind, in welche zugeordnete Lötstifte der Leiterplatte oder eines Sockels eingreifen. Somit durchläuft lediglich die mit den Lötstiften versehene Leiterplatte das Lötbad und nach Abschluß aller Verarbeitungsvorgänge wird das Relais auf die Lötstifte aufgesteckt.

FIG 1

## Steckbares Relais

Die Erfindung betrifft ein steckbares Relais nach dem Oberbegriff des Patenanspruchs 1. Die Erfindung ist jedoch nicht auf Relais beschränkt, sondern betrifft sämtliche steckbaren Bauteile, die über eine lösbare Steckverbindung mit anderen elektrischen Anschlüssen verbunden werden können. Derartige elektrische Anschlüsse können in Form von Leiterbahnen auf einer Leiterplatte angeordnet sein; sie können jedoch auch in Form von separat vorhandenen elektrischen Leitern gegeben sein.

Das bekannte Relais ist dadurch steckbar ausgebildet, daß im Federbock oder in einer Sockelplatte entsprechende Anschlußstifte eingelassen sind. Diese Anschlußstifte ragen über die Bodenfläche des Relais hinaus und sind zum Einstecken in einen Sockel gedacht, der hierfür entsprechende Aufnahmeöffnungen mit darin angeordneten Buchsen enthält. Der Sockel selbst wird dann in bekannter Weise auf einer Leiterplatte verlötet. Nachdem dieses Verfahren relativ umständlich ist und einen eigenen Sockel benötigt, verwendet man Relais mit Anschlußstiften, die unmittelbar auf einer Leiterplatte eingelötet werden. Nachteil dieser bekannten Montageart ist jedoch, daß das Relais erhöhten Ansprüchen hinsichtlich der Dichtigkeit, der Temperaturfestigkeit und der Säurebeständigkeit entsprechen muß, weil es im Lötbad entsprechenden schädlichen Einflüssen unterworfen wird. Das Relais muß hierbei zumindest lötdicht ausgebildet sein, was zu erhöhten Herstellungskosten führt. Auch das nachfolgende Waschen der mit Relais bestückten Leiterplatten erfordert eine absolute Dichtheit des Relais.

Der Erfindung liegt deshalb die Aufgabe zugrunde, ein Relais der eingangs genannten Art so weiterzubilden, daß es bei der Verwendung mit gedruckten Leiterplatten relative kostengünstig und einfach ausgebildet sein kann.

Zur Lösung der Aufgabe ist die Erfindung dadurch gekennzeichnet, daß im Relais Buchsen angeordnet sind, in welche zugeordnete Lötstifte einer zugeordneten Leiterplatte oder eines zugeordneten Sockels eingreifen.

Merkmal der vorliegenden Erfindung ist also die Umkehrung von Steckverbindung zu Buchsenverbindung im Vergleich dazu, wie sie herkömmlich verwendet wurde.

Im Relais selbst sind also Buchsen angeordnet, die mit zugeordneten Lötstiften auf der Leiterplatte zusammenwirken, so daß die Lötstifte in die Buchsen eingesteckt werden können.

Damit werden wesentliche Vorteile erreicht, denn die Leiterplatte kann nun fertig konfektioniert dem Lötbad zugeführt werden und auch den nachfolgenden Bearbeitungsvorgängen, ohne daß das Relais auf die Leiterplatte aufgesteckt sein muß. Es genügt daher, auf der Leiterplatte die entsprechenden Lötstifte anzubringen, welche das Lötbad durchlaufen, ohne daß das Relais selbst an den physikalisch hoch das Relais beanspruchenden Arbeitsvorgängen teilnimmt.

Erst nach vollständiger Fertigstellung der Leiterplatte wird das Relais mit seinen buchsenförmigen Aufnahmeöffnungen auf die Lötstifte der Leiterplatte aufgesteckt und die Leiterplatte ist damit fertig bestückt.

Dies führt dazu, daß das Relais nicht mehr löt- und waschdicht sein muß und überdies auch nicht mehr derartigen thermischen und chemischen Bestandteilen standhalten muß, wie sie vorher bei Relais gefordert waren, welche das Lötbad und die nachfolgenden Verarbeitungsgänge durchliefen.

Das Relais kann also einfach und kostengünstig ausgestaltet sein, und die Anordnung von entsprechenden Buchsen in dem Federbock eines Relais ist fertigungstechnisch einfach zu realisieren.

In einer Weiterbildung nach der vorliegenden Erfindung ist es vorgesehen, daß das Relais mittelbar über entsprechende Anschlußelemente mit einer Leiterplatte verbunden werden kann.

In einer bevorzugten Ausführungsform ist es hierbei vorgesehen, daß das Relais kontaktgebend mit entsprechenden Lötanschlußstiften einer Leiterplatte zusammenwirkt, die ihrerseits mit den gleichen oder mit anderen Lötstiften auf einen Sockel oder eine Adapterplatte aufgesteckt wird und die Adapterplatte bzw. der Sockel selbst dann mit entsprechenden weiteren Anschlußstiften auf eine Leiterplatte gelötet wird.

Die unmittelbar dem Relais zugeordnete Leiterplatte kann somit als Codierplatte aufgefaßt werden, mit der es möglich ist, eine Änderung der Buchsenzuordnung des Relais zu den Buchsen der darunter befestigten Doppel-bzw. Adapterplatte zu erreichen. Durch Verwendung dieser Leiterplatte als Codierplatte kann also das Relais universell einsetzbar sein und stets die gleiche Anschluß-Konfiguration aufweisen, wobei dann die spezielle für den Einbauort geforderte Anschluß-Konfiguration über die dem Relais zugeordnete Codierplatte und die zugeordnete Sockel-bzw. Adapterplatte hergestellt wird.

Weitere Merkmale der Erfindung sind Gegenstand der übrigen Unteransprüche.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

Im folgenden wird die Erfindung anhand von mehreren Ausführungswege darstellenden Zeichnungen näher erläutert. Hierbei gehen aus den Zeichnungen und ihrer Beschreibung weitere erfindungswesentliche Merkmale und Vorteile der Erfindung hervor.

Es zeigen:

Figur 1: schematisiert gezeichnete Seitenansicht eines Relais nach der Erfindung in seiner Endlage auf einer Leiterplatte,

Figur 2: schematisiert gezeichnete Seitenansicht in auseinandergezogener Darstellung eines Relais in einer zweiten Ausführungsform.

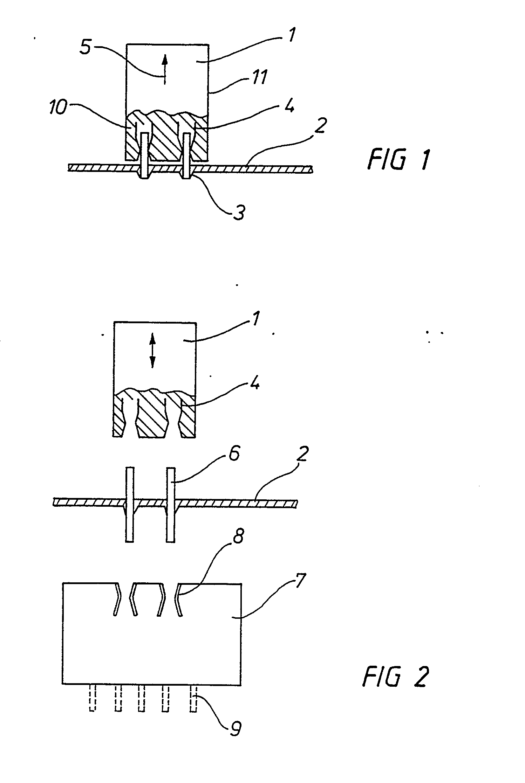

In Figur 1 ist beispielhaft ein Relais 1 als Kasten symbolisiert, wobei der Deutlichkeit halber auf die Darstellung einzelner Schaltelemente des Relais verzichtet wurde. Es wurde schon eingangs darauf hingewiesen, daß der vorliegende Erfindungsgedanke für alle steckbaren Bauteile gilt, nicht nur für Relais, daß die vorliegende Erfindung aber besonders für Relais geeignet ist.

Das Relais weist ein Gehäuse 11 auf, in dem - lediglich schematisiert dargestellt -ein Federbock 10 vorgesehen ist. Im Federbock 10 sind entsprechende Buchsen 4 in gegenseitigem Abstand angeordnet.

Auf der zugeordneten · Leiterplatte 2 sind Lötstifte 3 so eingelötet daß sie senkrecht zur Ebene der Leiterplatte 2 über die Ebene dieser Leiterplatte 2 herausstehen, so daß das Relais 1 mit seinen Buchsen 4 auf die Lötstifte 3 aufgesteckt wird und hierdurch der geforderte lösbare Kontakt gegeben ist. Das Relais kann somit in Pfeilrichtung 5 von der Leiterplatte 2 abgezogen werden.

In Figur 2 ist ein zweites Ausführungsbeispiel gezeigt, wo die Leiterplatte 2 als Codierplatte verwendet wird und hierbei Lötstifte 6 verwendet werden, die sowohl an der einen Seite, als auch an der anderen Seite der Leiterplatte 2 herausstehen, so daß an der einen Seite das Relais 1 mit seinen Buchsen 4 auf die Lötstifte 6 aufgesteckt werden kann und auf der anderen Seite ein Sockel 7 in den -schematisiert gezeichneten -Buchsen 8 eingebaut sind, die über nicht näher dargestellte elektrische Verbindungen mit an der Unterseite des Sockels 7 angeordneten Lötstiften 9 verbunden sind.

Die Lötstifte 9 brauchen nur fallweise vorhanden zu sein; es ist ebenso möglich, den Sockel 7 über andere nicht näher dargestellte Leiter mit den Buchsen 8 zu kontaktieren.

Durch die Verwendung der Leiterplatte 2 mit den Lötstiften 6 ist es nun möglich, die elektrische Konfiguration des Relais 1 mit seinen Buchsen 4 in Bezug zu den Lötstiften 9 des Sockels 7 zu ändern, ohne daß selbst Eingriffe im Relais 1 vorgenommen werden müssen.

In dem Zeichnungsbeispiel ist zeichnerisch nicht näher dargestellt, daß es auch möglich ist, Lötstifte 3 gemäß Figur 1 zu verwenden und an anderer Stelle der Leiterplatte andere Lötstifte 3, die nach unten zeigen und in die entsprechenden Buchsen 8 des Sockels 7 eingreifen.

Damit ist ebenfalls eine Veränderung der elektrischen Konfiguration des Relais 1 möglich.

Zeichnungslegende

    1 Relais
    2 Leiterplatte
    3 Lötstifte
    4 Buchse
    5 Pfeilrichtung
    6 Lötstift
    7 Sockel
    8 Buchse
    9 Lötstift
    10 Federbock
    11 Gehäuse

## Ansprüche

1. Steckbares Relais oder dergleichen mit am Gehäuse desselben angeordneten Verbindungskontakten, welche lösbar mit zugeordneten, eine elektrische Verbindung herstellenden und auf einer Leiterplatte angeordneten Steckelementen verbindbar sind, **dadurch gekennzeichnet,** daß eine die Steckverbindung zwischen dem steckbaren Relais - (1) und den Bahnen der Leiterplatte (2) herstellende Verbindungsplatte (7) vorgesehen ist, die auf Verbindungskontaktstifte (3) der Leiterplatte (2) mittels Steckaufnahmebuchsen (8) aufsteckbar ihrerseits Verbindungskontaktstifte (9) zur Kontaktgabe mit entsprechenden Steckaufnahmebuchsen (4) des Relais (1) aufweist.

2. Steckbares Relais nach Anspruch 1, **dadurch gekennzeichnet,** daß die Anordnung der Verbindungskontaktstifte (9) der Verbindungsplatte (7) der Kontakt-Konfiguration der Steckaufnahmebuchsen (4) des Relais (1) und die Steckaufnahmebuchsen (8) der Verbindungsplatte (7) der Konfiguration der Verbindungskontaktstifte (3) der Leiterplatte (2) angepaßt ist.

3. Steckbares Relais nach Anspruch 1 und 2, **dadurch gekennzeichnet,** daß die in der Leiterplatte (2) angeordneten Verbindungskontaktstifte (3) an beiden Seiten der Leiterplatte zur Kontaktgabe mit zugeordneten Steckaufnahmebuchsen (4, 8) von beidseits der Leiterplatte (2) aufsteckbaren Bauteilen (1, 7) vorgesehen sind.

4. Steckbares Relais nach Anspruch 3, **dadurch gekennzeichnet,** daß die internen elektrischen Verbindungen zwischen den Steckaufnahmebuchsen (8) und den Verbindungskontaktstiften (9) der Verbindungsplatte (7) den gewünschten Schaltfunktionen der beidseitig der Leiterplatte (2) gegenüberliegenden elektrischen Bauteile (1) anpaßbar ausgeführt sind.

FIG 1

FIG 2